Europäisches Patentamt

European Patent Office

Office européen des brevets

(11) Publication number: **0 425 242 A1**

# EUROPEAN PATENT APPLICATION

(21) Application number: 90311607.7

(51) Int. Cl.⁵: **H01L 29/73**, H01L 29/08

(22) Date of filing: 23.10.90

(30) Priority: 24.10.89 JP 276537/89

(43) Date of publication of application:
02.05.91 Bulletin 91/18

(84) Designated Contracting States:
**DE FR GB**

(71) Applicant: **SONY CORPORATION**
**7-35 Kitashinagawa 6-Chome Shinagawa-ku**
**Tokyo 141(JP)**

(72) Inventor: **Gomi, Takayuki, c/o Patents Division**
**Sony Corporation, 6-7-35 Kitashinagawa**
**Shinagawa-ku, Tokyo 141(JP)**
Inventor: **Miwa, Hiroyuki, c/o Patents Division**
**Sony Corporation, 6-7-35 Kitashinagawa**
**Shinagawa-ku, Tokyo 141(JP)**
Inventor: **Kayanuma, Akio, c/o Patents**
**Division**
**Sony Corporation, 6-7-35 Kitashinagawa**
**Shinagawa-ku, Tokyo 141(JP)**

(74) Representative: **Thomas, Christopher Hugo et**
**al**
**D Young & Co 10 Staple Inn**
**London WC1V 7RD(GB)**

(54) **Bipolar transistor structure.**

(57) A semiconductor device comprises one semiconductor region (1) in contact with another semiconductor region (3) and an impurity-containing semiconductor layer (2) formed on the one semiconductor region (1). An impurity diffusion inhibiting layer (4) is formed between the one semiconductor region (1) at least on a portion thereof adjacent to the other semiconductor region (3) and the impurity-containing semiconductor layer (2), so that the impurity from the impurity-containing semiconductor layer (2) is inhibited from being diffused near the other semiconductor region (3).

FIG. 1

EP 0 425 242 A1

## SEMICONDUCTOR DEVICES

This invention relates to semiconductor devices.

There have been proposed various types of ultra-high speed bipolar transistor which have an emitter, a base and a collector which are self-aligned, and are formed by doping with impurities through polycrystalline silicon. Such transistors have been disclosed, for example in Japanese laid-open patent specification 61/255064.

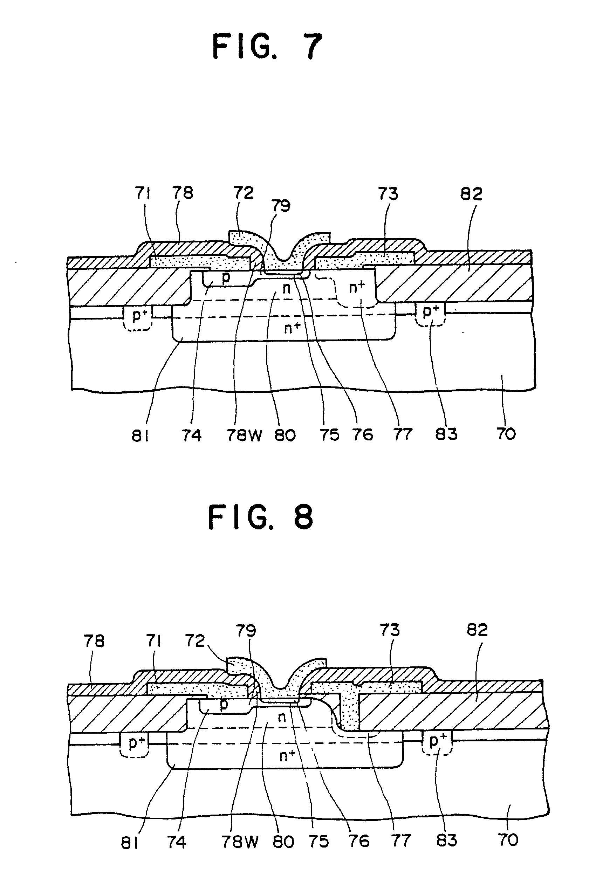

Figure 7 shows an example of such a transistor which comprises a semiconductor substrate 70, and polycrystalline silicon layers 71, 72 and 73 arranged as shown. A lead region 74 upon which an electrode for a base region is to be deposited is formed by doping an impurity from the layer 71. A working region 75 of a base and an emitter region 76 are formed by doping with an impurity through the layer 72. The layer 73 serves as a collector electrode and is deposited over a region 77 which serves as a lead electrode or electrode contact for the collector. An insulating interlayer 78 such as of $SiO_2$ is formed between the layers 71 and 73 and the layer 72, and the interlayer 78 has side walls 78W formed as shown. Prior to the formation of the side walls 78W and the formation of the layer 72, a base connection region 79 for connecting the working region 75 of the base and the lead region 74 for an electrode of the base is formed by ion implantation. A low concentration collector region 80 and a low specific resistance collector buried region 81 are also provided.

In this arrangement, the layer 73 which contains an impurity and which serves as the collector electrode directly contacts the substrate at the base side, so that the impurity from the impurity-containing polycrystalline silicon layer 73 will diffuse into the surface of the substrate 70, with the possibility that the collector side which is very close to or in contact with the base region will be highly concentrated. This will cause a lowering of the breakdown voltage between the base and the collector, with an attendant problem that short-circuiting may occur. It should be noted that in Figure 7, a thick $SiO_2$ insulating layer 82 for insulation separation, or a so-called LOCOS separation insulating layer, exists as well as a channel stop region 83.

Another example includes an arrangement, as shown in Figure 8, which includes a polycrystalline silicon layer 73 which extends through a part of a separation insulating layer 82. In this case, however, in spite of the fact that the sectional area of a portion of the silicon layer 73 extends through the separation insulating layer 82, the through portion is long and corresponds to the thickness of the separation insulating layer 82. This leads to a large collector resistance, which inhibits high speed operation of the bipolar transistor.

According to the present invention there is provided a semiconductor device comprising one semiconductor region in contact with another semiconductor region, an impurity-containing semiconductor layer formed on said one semiconductor region, and an impurity diffusion inhibiting layer formed between said one semiconductor region at least at a portion thereof adjacent to said other semiconductor region, whereby the impurities from said impurity-containing semiconductor layer are inhibited from diffusing into said other semiconductor region.

According to the present invention there is also provided a semiconductor device comprising a substrate, a collector region of a first conductivity type formed in said substrate, a base region of a second conductivity type formed in said substrate and laterally extending from said collector region, an emitter region of a first conductivity type formed in said substrate and extending to said base region, collector, emitter and base electrodes formed of impurity-containing material on said substrate and respectively contacting said collector, emitter and base regions, and an impurity diffusion inhibiting layer between said collector electrode and said substrate so as to prevent the collector to base resistance from being decreased by migration of impurities from said collector electrode to said base region.

According to the present invention there is also provided a semiconductor device of the type which has a semiconductor region in contact with another semiconductor layer formed on the semiconductor region, and an impurity diffusion inhibiting layer formed between the semiconductor region at least at a portion adjacent to another semiconductor region and the impurity-containing semiconductor layer, so that the impurity from the impurity-containing semiconductor layer is inhibited from being diffused near the other semiconductor region.

If the one semiconductor region is a lead region for a collector electrode and the impurity-containing semiconductor region is a collector electrode, the impurities from the collector electrode are inhibited from being diffused towards a portion which contacts another region such as a base region. Thus, lowering the breakdown voltage between the collector and base regions can be avoided.

The invention will now be described by way of example with reference to the accompanying drawings, throughout which like parts are referred to by like references, and in which:

Figure 1 is an enlarged, sectional view of an embodiment of semiconductor device according to the invention;

Figures 2A to 2K are enlarged sectional views of steps of fabricating the device of Figure 1;

Figures 3 to 6 are graphs of the concentration distribution of impurities; and

Figures 7 and 8 are enlarged sectional views of previously proposed semiconductor devices.

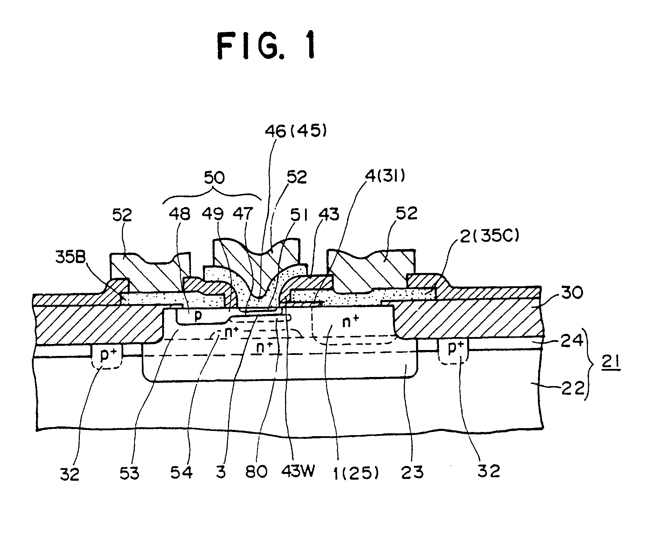

As shown in Figure 1, the embodiment comprises a given semiconductor region 1 and an impurity-containing semiconductor layer 2 in contact with or formed on the region 1. An impurity diffusion inhibiting layer 4 for inhibiting diffusion of an impurity is provided between a portion of the region 1 adjacent to or in contact with another semiconductor region 3 and the impurity-containing layer 2.

With this arrangement, the impurity-containing layer 2 which is in contact with the region 1 is separated from the region 1 at a portion of the region 1 adjacent to or in contact with the region 3 through the impurity diffusion-inhibiting layer 4 provided below the impurity-containing layer 2. Thus, the diffusion of an impurity from the impurity-containing layer 2 is prevented, so that a highly concentrated region is not formed in the vicinity of the region 3. This ensures an improvement in the breakdown voltage between the regions 1 and 3, and if the region 1 is a lead out region for a collector electrode and the region 3 is a base region, the breakdown voltage between the collector and the base, $V_{CBO}$ will be improved.

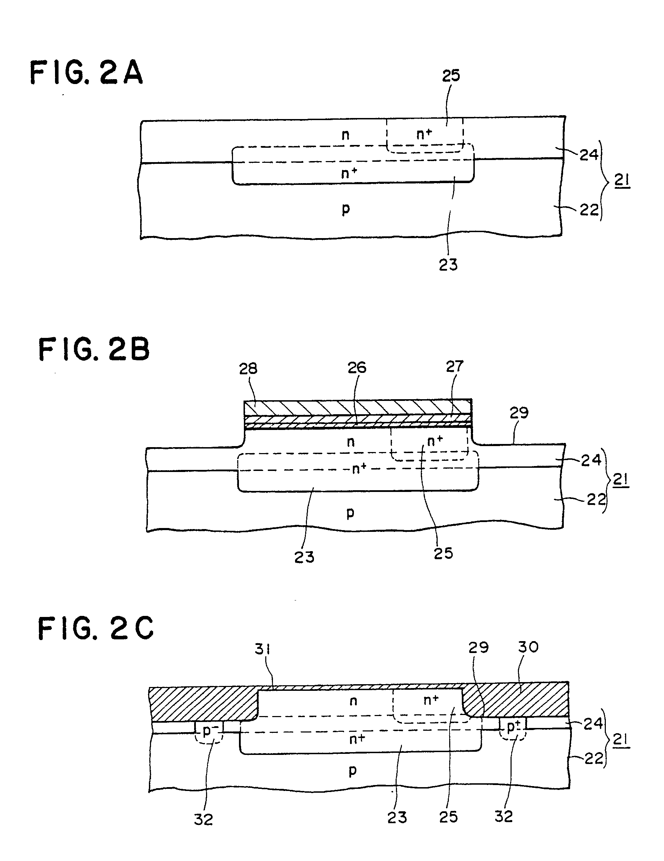

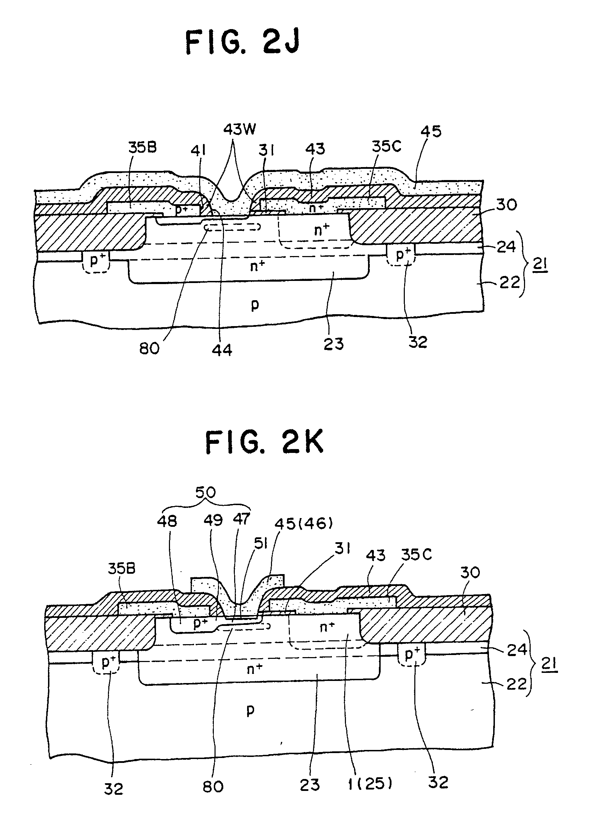

One embodiment wherein the invention is applied to a semiconductor integrated circuit which uses a bipolar transistor will now be described in more detail with reference to Figure 1 and Figures 2A to 2K.

As shown in Figure 2A, a semiconductor substrate 21 has, for example, a p type silicon substrate 22 of a first conductivity type selectively formed on the main surface thereof, and a buried layer 23 is formed which has a second conductivity type by having been selectively diffused with an n type impurity at a high concentration. An n type silicon semiconductor layer 24 is expitaxially grown on the substrate 22.

A lead region 25 for a collector electrode is formed by selective diffusion or ion implantation to a depth which allows contact with part of the buried layer 23 through the layer 24.

Thereafter, as shown in Figure 2B, a SiO₂ undercoat layer 26 is formed on the layer 24 such as, for example by surface thermal oxidation, and an oxidation-resistant mask layer 27 such as, for example of SiN (Si₃N₄) is formed on the entire surface of the layer 24. A photoresist layer 28 is then formed by an optical technique wherein a photoresist composition is applied and exposed to light and developed to form the layer 28 on a portion where a circuit element is to be formed, that is, on the buried region 23 in this embodiment. The mask layer 27 is selectively etched through a photoresist mask or an etched mask of SiO₂, not shown. The undercoat layer 26 is etched through the mask layer 27 to a desired depth with respect to the layer 24 so as to form a groove 29.

As shown in Figure 2C, the layer 24 at portions within the groove 29 which are not covered with the mask layer 27 is thermally oxidized on the surface thereof to form a thick separation insulabing layer 30. In other words, a 600 to 700 nm thick separation insulating layer 30 is formed by the so-called LOCOS process. Thereafter, the mask layer 27 and, if necessary, the undercoat layer 26 are removed, and the layer 24 is thermally oxidized to form a SiO₂ surface insulating layer 31 which has a thickness of approximately 100 nm on the thus removed layer 24 where the insulating layer 30 has not been formed. The surface insulating layer 31 serves as an impurity diffusion-inhibiting layer so that the impurities in the polycrystalline semiconductor are inhibited from being diffused as will be later described. In this connection, the separation insulating layer 30 and the surface insulating layer 31 should preferably be substantially at the same level, and thus, the depth of the groove 29 and the thicknesses of the layers 30 and 31 should be carefully selected. A pattern on the separation insulating layer 30 and the respective circuit element forming regions is formed, for example by ion implantation to provide channel stop regions 32 of a first conductivity type. The ion implantation is performed, for example as follows: a p type impurity, such as boron, is implanted from the separation insulating layer 30 at not less than 360 KeV at a dose of $10^{13}$ to $10^{14}$ cm⁻², for example at 1 × $10^{14}$ cm⁻², thereby forming the channel stop regions 32 to a depth across the layer 24.

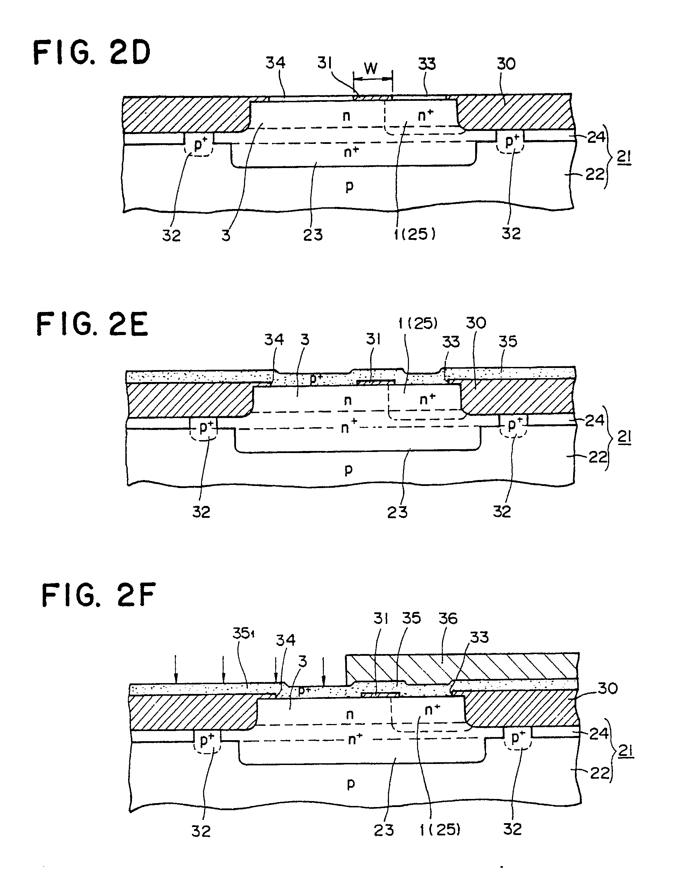

As shown in Figure 2D, the surface insulating layer 31 is selectively etched by photolithography to form openings 33 and 34 on the region 1, for example the lead region 25 for a collector electrode on which a collector electrode is to be deposited, and the adjacent region 3, respectively, with a distance W therebetween.

As shown in Figure 2E, a non-doped polycrystalline silicon semiconductor layer 35 without any impurity is formed, such as a chemical vapour deposition (CVD), on the regions 1 and 3 through the openings 33 and 34 in the surface insulating layer 31.

As shown in Figure 2F, a first mask layer 36, which is a mask for incorporating an impurity for covering a portion including at least the opening 33 or a portion which serves as an electrode and conductors for the region 1 or the lead region 25, is formed by a known optical technique (photographic technique) using a photoresist of a given pattern. A first conductivity type portion $35_1$ is formed by ion implantation of a first conductivity type impurity, for example a p type impurity such as boron, in the exposed portion of the layer 35 on which the first mask layer 36 has not been deposited.

As shown in Figure 2G, the first mask layer 36 is removed and a second mask layer 37 for impurity implantation made, for example of a photoresist, is formed in a reversed relationship to the pattern of the first mask layer 36. The second mask layer 37 is formed either by using an exposure mask with a reverse pattern (a pattern wherein light-transmitting and non-light-transmitting pattern portions are reversed) relative to the exposure mask used to form the first mask layer 36, or by using a photoresist layer of the positive type for the first mask layer and by using a photoresist layer of the negative type for the second mask layer 37. In either case, both mask layers 36 and 37 can be formed in reversed patterns with high precision. A second conductivity type impurity such as an n type impurity, for example phosphorus or arsenic, is ion implanted in an exposed portion of the layer 35 on which the second mask layer 37 has not been formed, thereby forming a second conduction-type portion $35_2$.

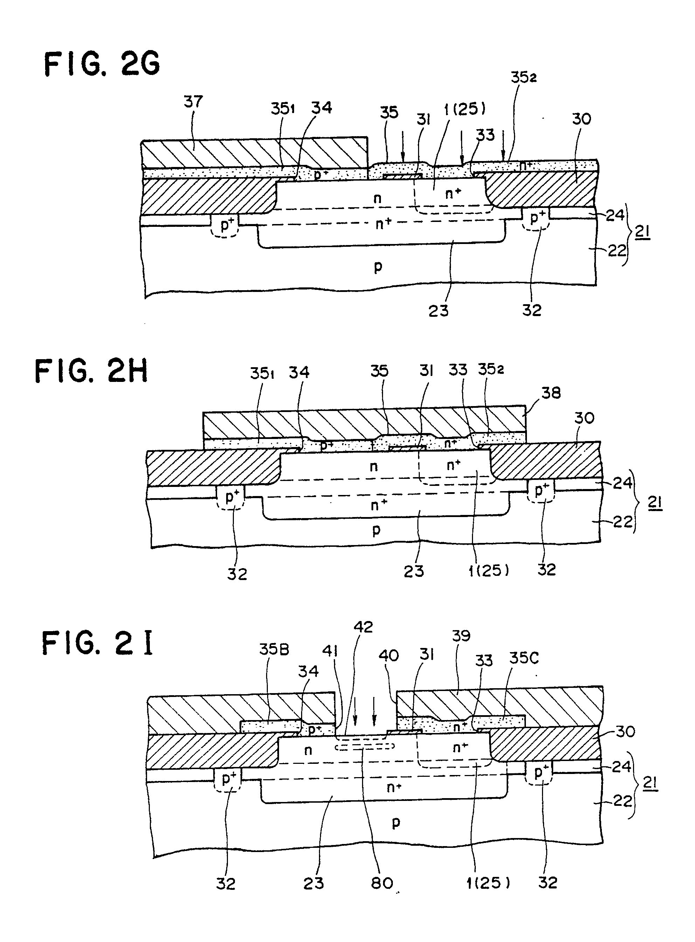

As shown in Figure 2H, an etching mask layer 38 such as a photoresist is selectively formed by an optical technique on a portion of the layer 35 where a collector electrode and a base electrode, and a base region and an emitter region are to be finally formed. The layer 35 is etched through the etching mask layer 38 to remove the portions not covered by the etching mask 38.

As shown in Figure 2I, the etching mask layer 38 is removed and an etching mask 39 such as a photoresist is entirely formed on the surface. The etching mask 39 is selectively removed to form a window for a portion where an emitter is to be finally formed and a portion where a connection base region for connecting the working region as the base and a lead region for the base electrode are to be formed. The layer 35 is etched through the window 40 so as to separate the layer 35 into a collector electrode (which may include conductors therefor) and a base electrode ( which may include conductors therefor) 35B. The base electrode 35B formed on the layer 24 is removed by etching through the window 24 except in an area which will finally serve as the lead region for the base electrode 35B, thereby forming a cut-away portion 41. The portion of the layer 24 which is exposed through the window 40 and the cut-away portion 41 is ion implanted with a first conduction type impurity, for example ap type impurity such as boron, to form an impurity ion implanted region 42. Although not shown in the figures, a second conduction type impurity is deeply ion implanted to form a first conduction type region 80 which serves to regulate the depth of a final base region.

As shown in Figure 2J, an insulating layer such as $SiO_2$ is formed by CVD with a given thickness over the entire surfaces including those in the cut-away portion 41, followed by thermal annealing so as to form a mask layer 43 which is difficult to remove by light etching, and then by etching back to form side walls 434 on the inner side of the cut-away portion 41. As a result, a window 44 which has an inner diameter which is smaller than that of the cut-away portion 41 is formed so as to expose a portion of the ion-implanted region 42 of the layer 24 at an area where an emitter is finally to be formed. A polycrystalline silicon semiconductor layer 45 is formed by CVD over the entire surface including in the window 44.

As shown in Figure 2K, the layer 45 is etched in a pattern by photolithography so as to form an emitter electrode (including conductors thereof) 46. A first conduction type impurity is ion implanted through the layer 45 as the emitter electrode 46, followed by thermal annealing to form a base working region 47 by diffusion and activation of the implanted impurity, and to form a base lead out region 48 by diffusion and activation of the impurity from the base electrode 35B. At the same time, there is formed a base connection region 49 for connecting the regions 47 and 48 by diffusion and activation of the impurity from the ion-implanted region 42. In this manner, a base region 50 is formed of the regions 47, 48 and 49. In this connection, the p type impurity of the region 47 is offset by the impurity-incorporating region 80 in which n type impurity has been deeply implanted, so that the depth of the region 47 will be small. Thereafter, a second conduction type impurity is ion implanted through the layer 45 and thermally annealed to form an emitter region 51, and the layer 45 is doped with an impurity so as to provide the low resistance emitter electrode 46.

As shown in Figure 1, the mask layer 43 is formed with windows for electrodes on the collector electrode 35C. The emitter electrode 46 and the base electrode 35B are each made of a polycrystalline silicon semiconductor layer, on which a conductive layer 52 made of a metal such as aluminium formed overall by vacuum deposition and then etched in a pattern by photolithography, thereby making the collector, base and emitter electrodes which have low resistance.

In some cases, in place of the conductive layer 52 of aluminium, a low-resistance metallic layer such as tungsten may be deposited on the respective layers 35C, 35B and 45 for silicidation or to form a so-called polysilicide layer on the polycrystalline layer.

If arranged as set forth above, a collector region 53 is formed by a portion of the n type layer 24 on the buried region 23, and the collector lead region 25 is formed on a portion thereof. On the collector region 53 there is formed the base region 50 formed of the base working region 47, the base connection region 49 and the lead out region 48 for a base electrode, so that a pnp type transistor is formed in which the emitter region 51 formed on the working region 47 of the base region 50 is self-aligned.

In this device, the collector electrode 35C, that is the impurity-containing semiconductor layer 2, formed on the semiconductor region 1, that is the lead region 25 for a collector electrode in this embodiment, is provided with the impurity diffusion inhibiting layer 4 of the surface insulating layer 31 at the side where another region 3 or the base region 50 is formed. Accordingly, the impurity from the impurity-containing semiconductor layer 2 is suppressed from diffusing into the vicinity of the base region, thus preventing the lowering of the breakdown voltage, $V_{CED}$ between the collector and the base.

In the embodiment described above, the channel stop regions 32 are formed, as shown in Figure 2C, by ion implantation through the thick separation insulating layer 30. In some cases, after formation of the groove 29 illustrated in Figure 2B, the channel stop region 32 may be formed by selectively diffusing an impurity of a first conductivity type, that is the p type impurity in this embodiment, into a given portion. In this case, however, after the formation of the channel stop region 32 by diffusion, when heating at high temperatures for a long time, for example in the LOCOS treatment by which the thick separation insulating layer 30 is formed, the channel stop region 32 is enlarged so that it extends to the neighbourhood of the buried region 32, with the possibility that the breakdown voltage is lowered. Thus, where an area which is sufficient to provide the channel stop region 32 is provided, taking into account the possible enlargement of the channel stop region 32, the total area becomes undesirably large. Additionally, the enlargement of the channel stop region 32 may accompany an increase in the junction area, resulting in ati increase in the parasitic capacitance. As set forth relative to Figures 2A to 2I, when the channel stop region 32 is formed by deep ion implantation after the LOCOS treatment or the formation of the thick separation insulating layer 30, the above listed disadvantages can be prevented.

In the semiconductor device described above, when the base connection region 49 is provided for making connection between the working region 47 and the lead out region 48 for a base electrode in the base region 50 as illustrated in Figures 2A to 2K, the connection between the working region 47 and the lead region 48 is assured, which results in the lowering of the base resistance Rb. However, when a connection region 49 is provided, the depth of the base becomes large which inevitably leads to a greater depth of the working region 47. This may cause a large width of the base which causes lowering of the current amplification factor. As described with reference to Figure 2I, when the impurity-incorporating region 80 is formed below the emitter region 51 at a given distance, the downward extension of the base region 50 can be compensated with the impurity of the region 80, thereby regulating the depth of the base region 50.

On the other hand, in this type of semiconductor device, the collector resistance may be reduced by a method wherein as shown in Figure 1, a so-called pedestal region 54 of the collector which projects towards the side of the base region on the buried region 23 is formed by ion implantation.

In this case, the compensation method for regulating the depth of the base region 50, that is the ion implantation for forming the impurity-incorporating region 80, and the ion implantation for forming the pedestal region 54 both use ion implantation having an impurity of the same conductivity type. Accordingly, it has been checked as to whether both steps could be conducted at the same time. However, it was found that it was not desirable to perform these steps at the same time.

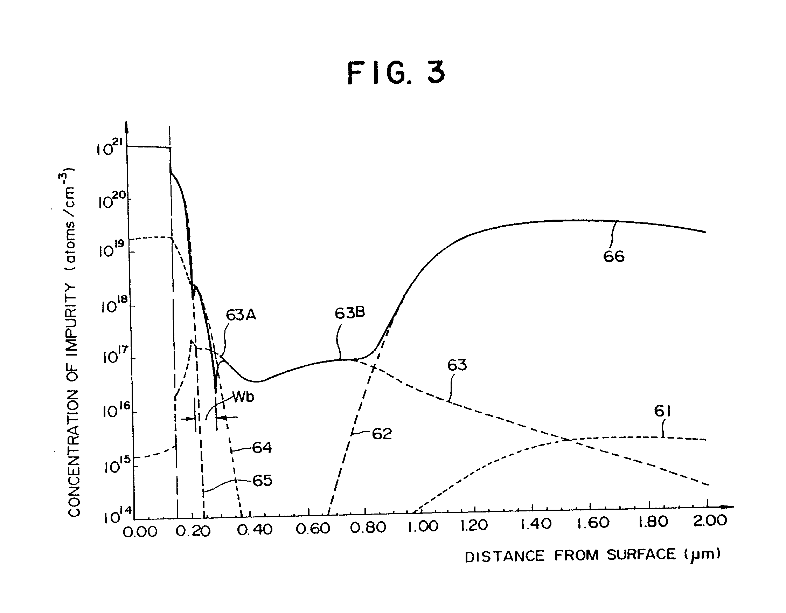

More particularly, when the impurity-incorporating region 80 is formed by ion implantation of an n type impurity, for example phosphorus, at an energy, for example of 100 KeV at a dose of 2 x $10^{12}$cm$^{-2}$, the formation of the pedestal region 54 provided on the collector buried region to lower the collector resistance is effected by dosing an n type impurity, for example phosphorus, at an energy of 300 KeV at a dose of 2 x $10^{12}$cm$^{-2}$. The concentration distribution of the impurity is shown in Figure 3 in relation to the depth from the surface of the polycrystalline silicon semiconductor layer 46 to the semiconductor substrate of the resultant bipolar transistor. Curve 61 indicates the concentration distribution of p type boron in the substrate 22, and curve 62 indicates the concentration distribution of an n type arsenic impurity in the collector buried region 23. Curve 63 indicates the concentration distribution of an n type phosphorus impurity in the epitaxial semiconductor layer 24, the impurity-incorporation region 80 for compensation, and the pedestal region 54. Curve 64 indicates the concentration distribution of p type boron impurity in the base region, and curve 65 indicates the concentration distribution of n type arsenic impurity in the emitter region 51. In Figure 3, solid line curve 66 indicates the concentration distribution of the total impurities. As shown by curve 63, the base width Wb is reduced in size due to the compensation of the p type impurity resulting from the presence of the portion 63A produced by the ion implantation for the compensation. On the other hand, the collector concentration is increased in the vicinity of the base due to the highly concentrated distribution portion 63B produced as shown in curve 63 by the ion implantation which is used to form the pedestal region 54, and this forms the pedestal region 54 thereby reducing the collector resistance.

The reason why the ion implantation step of forming the impurity-incorporating region 84 for compensation and the ion implantation for the formation of the pedestal region 54 are effected separately, is due to the fact that as stated before, the conditions for ion implantation which can satisfy both the ion implantation for the compensation and the ion implantation for forming the pedestal region 54 are not the same.

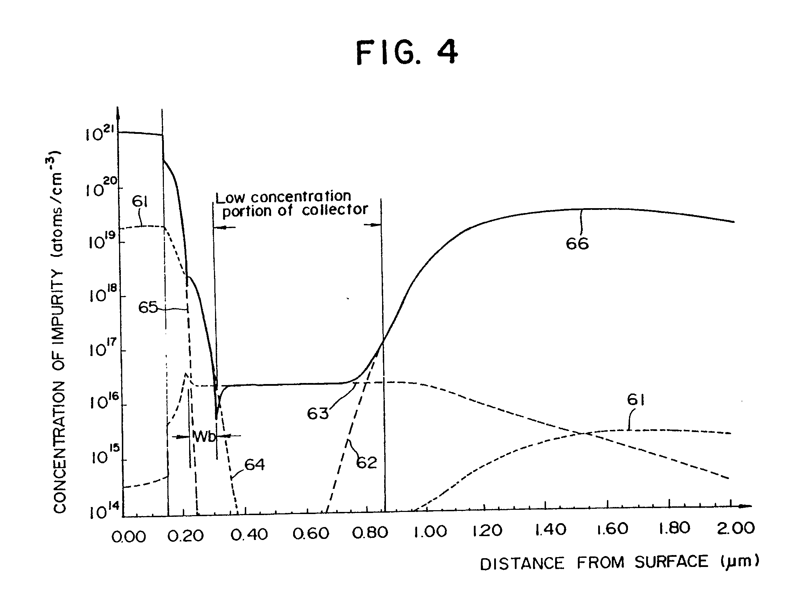

In Figure 4, there is shown the concentration distribution of impurities for a case where the ion implantation for the compensation and the ion implantation for the formation of the pedestal region 54 are not effected. In Figure 4, like reference numerals as in Figure 3 indicate like curves. In this case, the base width Wb becomes greater than that in Figure 3 and the width of the low concentration portion of the collector also becomes greater than in Figure 3.

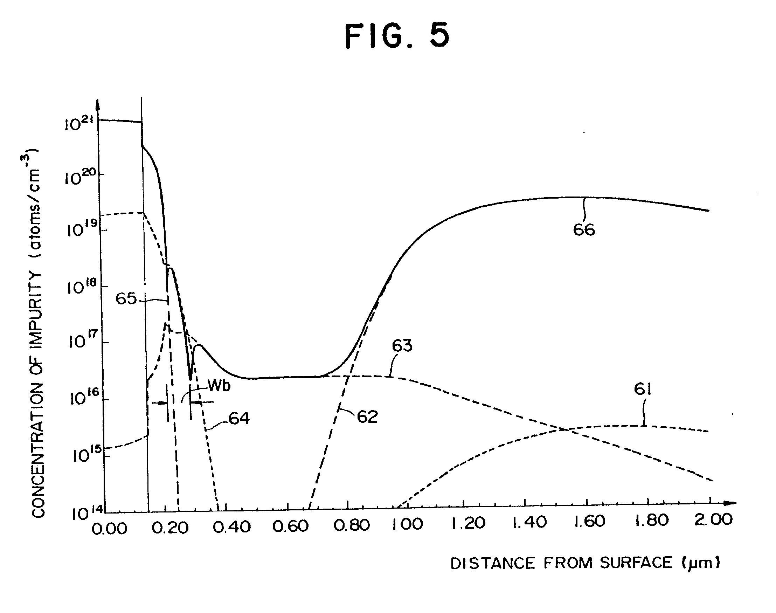

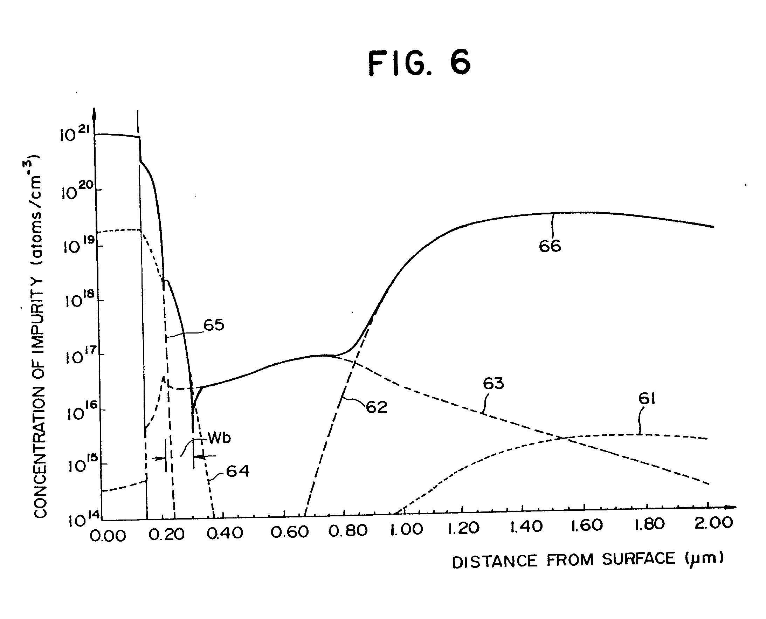

In contrast, when, for example ion implantation of phosphorus is effected at 100 KeV at a dose of $2 \times 10^{12} cm^{-2}$, the concentration distribution becomes as shown in Figure 5. The impurity concentration distribution where phosphorus is ion implanted at a higher energy of 360 KeV at the same dose of $2 \times 10^{12} cm^{-2}$, is shown in Figure 6. In Figures 5 and 6, curves which correspond to those in Figure 3 are indicated by the same reference numerals. As will become apparent by a comparison between Figures 5 and 6, where the ion implantation at the low energy as in Figure 5 is effected, the base width Wb can be reduced, but any pedestal effect of narrowing the low concentration portion of the collector is not produced. When the ion implantation energy is increased, little effect of reducing the base width Wb is expected as will be apparent from Figure 6. The comparison between the curves shown reveals that compensation and pedestal portion-forming effects cannot both be obtained either by the lower energy implantation for compensation or by the high energy ion implantation for forming the pedestal region 54.

In the above embodiment, as illustrated in Figure 2K, the impurity is obtained through the polycrystalline silicon semiconductor layer 45 in the emitter and the base. In this case, a natural oxide is formed at the interface between the polycrystalline semiconductor layer 45 and the silicon semiconductor layer 42. For instance, an approximately 0.5 to 1 nm thick oxide film is formed on the polycrystalline silicon semiconductor 45 during the CVD. The formation of this oxide film is not uniform. Accordingly, when an impurity is incorporated in the base and emitter regions, scattering may take place at the junction location causing the characteristics to be non-uniform.

In order to avoid this disadvantage, prior to the formation of the polycrystalline silicon semiconductor layer 45, the naturally occurring oxide film may be removed for a short time at high temperatures by irradiation with heat rays such as from halogen lamps, excimer lasers or xenon lamps. Alternatively, after formation of the polycrystalline silicon semiconductor layer 45, it may be annealed in an insert gas such as argon, or in a reducing gas system such as $H_2$ for a short time at high temperatures, so that the oxide film is diffused into the polycrystalline silicon. Still alternatively, the oxide film may be removed by reduction.

In the above embodiment, an npn transistor is obtained but the present invention may also be applied to produce a pnp transistor.

In the device described above, the impurity diffusion inhibiting layer 4, that is a $SiO_2$ surface insulating layer 31, is provided on a certain region 1 of the semiconductor substrate 21, for example the region to which a collector electrode is attached, and below the impurity-containing semiconductor layer 2, for example the collector electrode 35C, so that another region 3, that is the base region 50, is inhibited from diffusing the impurity from the impurity-containing semiconductor layer 2. Thus, there is avoided the disadvantage caused by diffusion of the impurity from the impurity-containing semiconductor layer 2 to a position which contacts the base region 50, thus causing the collector side at a high concentration of the impurity to lower the breakdown voltage. Moreover, the impurity diffusion inhibiting layer 4 is provided with the opening 33, through which a contact portion of the impurity-containing semiconductor layer 2, that is the collector electrode 35C, is formed. If the opening is formed so as to have a satisfactory width, the collector resistance can be reduced.

**Claims**

1. A semiconductor device comprising one semiconductor region (1) in contact with another semiconductor region (3), an impurity-containing semiconductor layer (2) formed on said one semiconductor region (1), and an impurity diffusion inhibiting layer (4) formed between said one semiconductor region (1) at least at a portion thereof adjacent to said other semiconductor region (3), whereby the impurities from said impurity-containing semiconductor layer (2) are inhibited from diffusing into said other semiconductor region (3).

2. A device according to claim 1 wherein said one semiconductor region (1) is a lead-out region for a collector electrode, said other region (3) is a base region, and said impurity-containing semiconductor layer (2) is a collector electrode.

3. A device according to claim 1 wherein said impurity diffusion inhibiting layer (4) is provided with an opening which allows the contact of said one semiconductor region (1) with said impurity-containing semiconductor layer (2) and which has a width sufficient to lower the collector resistance.

4. A device according to claim 3 wherein said impurity diffusion inhibiting layer (4) is formed of $SiO_2$.

5. A semiconductor device comprising a substrate (21), a collector region (53) of a first conductivity type formed in said substrate (21), a base region (50) of a second conductivity type formed in said substrate (21) and laterally extending from said collector region (53), an emitter region (51) of a first conductivity type formed in said substrate (21) and expending to said base region (50), collector, emitter and base electrodes formed of impurity-containing material on said substrate (21) and respectively contacting said collector, emitter and base regions (53, 51, 50) , and an impurity diffusion inhibiting layer (2) between said collector electrode and said substrate (21) so as to prevent the collector to base resistance from being decreased by migration of impurities from said collector electrode to said base region (50).

6. A device according to claim 5 including a buried layer (80) formed in said substrate (21) beneath said emitter region (51).

# FIG. 1

## FIG. 2A

## FIG. 2B

## FIG. 2C

FIG. 2D

FIG. 2E

FIG. 2F

# FIG. 2G

# FIG. 2H

# FIG. 2I

# FIG. 2J

# FIG. 2K

FIG. 3

EP 0 425 242 A1

FIG. 4

EP 0 425 242 A1

FIG. 5

EP 0 425 242 A1

# FIG. 6

EP 0 425 242 A1

# FIG. 7

# FIG. 8

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X,Y | IBM TECHNICAL DISCLOSURE BULLETIN. vol. 25, no. 7b, December 1982, NEW YORK US pages 4019 - 4022; C.G.Jambotkar: "Method of Fabricating a Compact Transistor Structure"<br>* the whole document *<br>– – – | 1-5,6 | H 01 L 29/73<br>H 01 L 29/08 |
| Y | EP-A-0 329 401   (SONY CORPORATION)<br>* abstract; figure 2 *<br>– – – | 6 | |
| A | Internation Electron Device Meeting, San Fransisco, Dec 11-14 1988 IEEE, New York, USA pages 744 - 747; T.Gomi et al.: "A Sub-30psec Si Bipolar LSI Technology"<br>* figure 3 *<br>– – – – – | 5 | |
| | | | TECHNICAL FIELDS SEARCHED (Int. Cl.5) |
| | | | H 01 L |

The present search report has been drawn up for all claims

| Place of search | Date of completion of search | Examiner |
|---|---|---|
| The Hague | 18 January 91 | NILES N.P.E. |